(19) Europäisches Patentamt
European Patent Office
Office européen des brevets

(11) Publication number: 0 138 965
B1

(12) EUROPEAN PATENT SPECIFICATION

(45) Date of publication of patent specification: 14.10.87

(51) Int. Cl.4: C 30 B 25/02, C 30 B 29/40

(21) Application number: 84901516.9

(22) Date of filing: 15.03.84

(86) International application number:
PCT/US84/00403

(87) International publication number:
WO 84/03905 11.10.84 Gazette 84/24

# (54) TETRAMETHYLTIN DOPANT SOURCE FOR MOCVD GROWN EPITAXIAL SEMICONDUCTOR LAYERS.

(30) Priority: 04.04.83 US 482092

(43) Date of publication of application:
02.05.85 Bulletin 85/18

(45) Publication of the grant of the patent:
14.10.87 Bulletin 87/42

(84) Designated Contracting States:
BE CH DE FR GB LI NL SE

(58) References cited:
US-A-4 066 481

Progress in Solid State Chemistry, vol. 10, part 3 pp. 157-191 (1975)

Journal of Applied Physics", vol. 49, no. 9, September 1978, pp. 4854-4861

(73) Proprietor: Hughes Aircraft Company
7200 Hughes Terrace P.O. Box 45066
Los Angeles California 90045-0066 (US)

(72) Inventor: PARSONS, James, D.
596 Strauss Drive
Newbury Park, CA 91320 (US)

(74) Representative: Colgan, Stephen James et al
CARPMAELS & RANSFORD
43 Bloomsbury Square
London WC1A 2RA. (GB)

EP 0 138 965 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

Technical field

The present invention generally relates to the chemical vapor deposition (CVD) growth of doped epitaxial semiconductor layers, and, in particular, to the use of tetramethyltin (TMT) as a dopant source in metal organic chemical vapor deposition (MOCVD) reactor systems to permit the growth of tin-doped epitaxial compound and compound alloy semiconductor layers.

Background of the invention

The metal organic chemical vapor deposition technique is generally known as permitting the epitaxial growth of semiconductor layers on the surface of an appropriate substrate. The technique permits the growth of a uniform epitaxial layer having a controlled thickness within the range of approximately 10 nm (100Å) to greater than several micrometers over an area equal to that of conventional semiconductor substrates. While the most common application of MOCVD is to provide gallium arsenide (GaAs) epitaxial layers on the surface of a GaAs substrate, the MOCVD technique is not necessarily so limited. The technique generally involves the provision of any number of vapor phase-metal alkyl and hydride compounds in close proximity to a heated substrate surface. The temperature is closely controlled so as to be appropriately above the decomposition temperature of the alkyl and hydride compounds such that they decompose permitting the respective metal/semiconductor compounds to further react and deposit as a compound semiconductor material layer on the surface of the substrate. The remaining organic fractions further react to form highly volatile, noncontaminating vapor phase compounds that are easily removable from the general proximity of the substrate. For the formation of a GaAs epitaxial layer, trimethylgallium (TMG) and arsine are typically used. The ideal reaction proceeds as shown below:

$$(CH_3)_3Ga+AsH_3 \xrightarrow[\Delta]{H_2\ carrier} GaAs\downarrow +3CH_4\uparrow .$$

Additional alkyls, such as trimethylaluminum, and hydrides, such as phosphine, may be employed to form compound and compound alloy epitaxial layers having a desired composition analogous to $Al_xGa_{1-x}As_yP_{1-y}$, where x and y may vary independently between 0 and 1. Further, alkyl and hydride compounds may be appropriately selected so that the deposited elemental reactant fraction dopes the epitaxial layer to a desired carrier concentration and conductivity type. In the growth of a GaAs epitaxial layer, a p-type conductivity can be obtained by the deposition of a zinc dopant provided by the decomposition of dimethylzinc. Correspondingly, an n-type conductivity can be obtained by the deposition of a sulfur dopant provided by the decomposition of hydrogen sulfide.

There are substantial and highly desirable applications for semiconductor devices fabricated using, inter alia, successive depositions to produce a series of epitaxial layers. There are further advantages that can be obtained by having abrupt or precisely graded junctions between the layers and by further providing a precise concentration of a dopant to realize a particular conductivity type, carrier concentration, and dopant profile. In practice, however, a number of interrelated problems have prevented the fabrication of such a succession of doped epitaxial layers. The principal problem involves identifying a dopant species that can be suitably transported as a vapor-phase metal-organic compound into close proximity to the substrate. A number of potential dopants, such as silver, simply fail to form a useful metal-organic compound.

Another problem is that, following the decomposition of the metal-organic compound, the dopant may fail to either physically or electrically incorporate into the growing epitaxial layer. The failure to physically incorporate into the layer results in a phenomenon generally known as "surface pile-up". This phenomenon is attributed to a kinetics interaction between the various materials present at the growth surface of the epitaxial layer. The dopant species is constantly supplanted from lattice sites immediately beneath the growth surface as the deposition process proceeds. Consequently, the underlying epitaxial layer is left effectively undoped.

Failure of the dopant species to electrically incorporate is largely the result of the dopant species having a highly amphoteric characteristic in the particular semiconductor growth material. An amphoteric dopant, as is generally well-known, has a propensity to fill vacancies within the semiconductor lattice as both a donor and acceptor. A highly amphoteric dopant has a donor-type to acceptor-type vacancy fill ratio that approaches unity. This ratio is also known as the ratio of self-compensation and is an indication of the degree to which the dopant fails to be electrically active as a dopant of a particular conductivity type and, thereby, contribute to the carrier concentration within the layer.

Another problem with the MOCVD growth of precisely doped epitaxial layers involves the use of a metal-organic transport compound that effectively contaminates either the reactor system or the substrate. The transport compound must be such that it remains in the vapor phase until it is in close proximity to the substrate. Condensation onto and subsequent evaporation from tube walls within the reactor system results in delayed, and therefore improper, doping of subsequently grown epitaxial layers. This further results in an unpredictable dopant grading of the epitaxial layer as well as the junction between the growing layer and the previous layer. This improper

delayed-doping is generally referred to as the "memory-effect" phenomenon.

The dopant transport compound must also have a reasonably narrow decomposition temperature range such that the decomposition can be controlled to only occur sufficiently close to the substrate. Decomposition of the dopant transfer compound at too great a distance from the substrate results in the deposition of the dopant onto the reactor walls and a consequential contamination of the reactor system. Unless the reactor is clean of such deposits, the improperly deposited dopants will slowly evaporate during subsequent epitaxial growths and unpredictably dope the layers. Thus, these deposits act as delayed dopant sources that, consequently, also give rise to the memory-effect phenomenon.

Finally, the dopant transport compound itself must be such that, following decomposition, no contaminating reaction product is produced. The non-dopant fraction of the compound must be either non-reactive or particularly reactive with the transport compound carrier gas (typically hydrogen) and highly volatile so as to be easily removed from the vicinity of the substrate without contaminating either the substrate or the reactor system.

The delayed doping of MOCVD grown epitaxial layers may also occur in the absence of dopant transport compound condensation and the improper deposition of a dopant within the reactor system. During the early stages of the deposition of an epitaxial layer, a previously deposited epitaxial layer may also act as a delayed-dopant source. The dopants in the underlying layer, proportional to their particular volatility, will out-diffuse into the growing epitaxial layer. Thus, the two epitaxial layers, as well as the junction between them will be unpredictably graded or compensated, depending on the relative conductivity types of the two layers.

## Summary of the invention

The general purpose of the present invention is to provide a metal-organic transport compound that permits the MOCVD growth of readily reproducible tin doped Group III—V compound semiconductor epitaxial layers.

According to the present invention there is provided a process of epitaxially depositing in a metal-organic chemical vapor deposition (MOCVD) system including a reactor chamber, a layer of Group III—V compound semiconductor material having an n-type conductivity onto a substrate maintained within said reactor chamber, said process being characterized in that an elemental species which acts as a dopant to provide said layer with said n-type conductivity is obtained from the decomposition of a vapor phase organometallic compound consisting of tetramethyltin, wherein said tetramethyltin is conveyed into said reactor chamber by a carrier gas, the pick-up of said tetramethyltin from a source of tetramethyltin by said carrier gas being dependent upon the vapor pressure of said tetramethyltin source and the vapor pressure being variably controlled by controlling the temperature of said tetramethyltin source within the range of approximately −20.6° and −110°C while maintaining the temperature of the substrate between approximately 400° to 900°C during the epitaxial deposition of said layer.

An advantage of the present invention is that there is no significant contamination of either the substrate or the reactor system through the use of tetramethyltin as the transport compound.

Another advantage of the present invention is that tin, deposited as a consequence of the decomposition of tetramethyltin, has a high physical and electrical incorporation efficiency.

A further advantage of the present invention is that tetramethyltin has a high vapor pressure, while tin has a relatively low vapor pressure that, in combination, effectively prevents the occurrence of delayed doping.

Other attendant advantages of the invention will become apparent and readily appreciated as the same becomes better understood by reference to the following detailed description.

## Detailed description of the invention

The present invention can be utilized advantageously in substantially all conventional MOCVD reactor systems including those shown in U.S. Patents 4,108,106, 3,916,822, 3,704,987 and 3,633,537.

In accordance with the present invention, tetramethyltin [$(CH_3)_4Sn$] or TMT, an organometallic compound, is effectively utilized as a dopant transport compound to provide for the tin doping of an epitaxial layer of a Group III—V compound semiconductor material, such as GaAs, grown in a conventional MOCVD reactor system. In order to control the mole fraction of the transport compound that is picked up by the carrier gas, preferably hydrogen, and conveyed thereby into the reaction chamber, a reservoir of TMT is maintained in a typical bubbler vessel. The mole fraction of the TMT transport compound picked up by the carrier gas from this TMT source can be controlled in two ways. The first is to utilize different methods of enabling the TMT to be picked up by the carrier gas. These methods include simply bubbling the carrier gas through the TMT source. Another is to pass the carrier gas over the surface of the TMT within the bubbler vessel. In this case, the reduced TMT surface area presented to the carrier gas flow naturally results in a lower mole fraction pick-up of the TMT. Still another method is to pass the carrier gas by the outlet of a capillary flow limited TMT effusion source or, more simply, by bypassing the inlet and outlet tubes of a conventional bubbler containing TMT such that it effectively acts as an effusion source. Naturally, the mole fraction pick-up of TMT from an effusion source will be the lowest of these three methods.

The second way of controlling the mole fraction of the TMT picked up is to significantly reduce the temperature of the TMT, thereby lowering its

vapor pressure. A lesser amount of TMT is inherently picked by the carrier gas as compared to the identical situation where the TMT is maintained at a higher temperature. Naturally, temperature/vapor pressure control can be employed in combination with the various TMT bubbler configuration pick-up methods so as to permit the desired mole fraction of TMT to be carried into the reactor chamber.

A factor of great importance in the accurate utilization of organo-metallics is the substantial elimination of the memory-effect phenomenon. As explained above, the memory-effect phenomenon results in large part from condensation of the organo-metallic compound within the reactor system and from the improper deposition of the dopant onto the inner surfaces of the reactor chamber instead of the growing surface of the epitaxial layer. Condensation of the organometallic is avoided by maintaining the reactor system as a whole and, in particular, the inner surfaces of the gas lines and reactor chamber at a temperature above that of the vapor phase transport organo-metallic compound. In the case of the present invention, the gas line and the reaction chamber inner surfaces can be maintained conveniently at approximately room temperature by stipulating that the TMT source be maintained at a temperature below approximately −20.6°C and preferably within the approximate temperature range of −48° to −110°C. At −20.6°C, the vapor pressure of TMT is 13.3 Pa (10 mm of mercury) at normal atmospheric pressure. In the context of MOCVD reactor systems, this is considered to be a high vapor pressure, though sufficiently controllable in terms of obtaining a dopant transport compound/carrier gas mixture having a useful mole fraction of TMT. However, the TMT source vapor pressure can be substantially reduced in an accurately controllable manner by progressively reducing the temperature of the TMT source down to approximately −54°C, the freezing point of TMT. Once the TMT source has frozen, its vapor pressure can be further controllably reduced, though at a lower rate, by continuing to reduce the temperature of the TMT source. As a practical matter, no further reduction in the TMT vapor pressure need be realized by reducing the TMT source temperature beyond approximately −110°C. The temperature range of −20.6° to −110°C corresponds to a broad range of vapor pressures. Thus, the TMT source temperature range corresponds to a broad vapor pressure range that, in combination with the various bubbler configurations, permits the easy and accurately controllable carrier gas pick-up of a desired mole fraction of TMT.

The proper deposition of the dopant fraction of the transport compound on the substrate growth surface can be effectively enhanced by stipulating that the transport compound decomposition temperature range be sufficiently restricted and below the substrate temperature such that the transport compound decomposes only in the reactor chamber and is fully decomposed by the time it arrives in close proximity with the epitaxial growth surface. Naturally, the substrate must be maintained at a temperature that is below the temperature that will in any significant way disturb the substrate. In the case of the present invention, the decomposition temperature range of TMT is substantially between 200° and 400°C. By maintaining the substrate above this range, i.e. between approximately 400° to 900°C, the decomposition of the TMT occurs in sufficiently close proximity to the epitaxial growth surface such that substantially all of the tin dopant is properly deposited on the epitaxial growth surface. For the growth of GaAs epitaxial layers, the substrate is generally maintained between 600° and 900°C so as to enable the appropriate decomposition of the trimethylgallium and arsine. Consequently, a preferred substrate temperature is approximately 700°C.

Tin that is improperly deposited on the walls of the reaction chamber is effectively precluded from acting as a delayed-dopant due to its exceptionally low vapor pressure; lower, in fact, than any of the Group VI elements that are conventionally utilized as n-type dopants in MOCVD grown GaAs epitaxial layers. Any improperly deposited tin simply fails to evaporate from the reactor surface at any significant rate. There is, therefore, no observable memory effect phenomenon due to the use of TMT to provide tin as a dopant.

The organic components of the decomposition reaction must also not act as a source of contamination to either the reactor system or the substrate and any epitaxially grown layers present thereon. In the case of the epitaxial growth of a tin-doped gallium arsenide epitaxial layer utilizing a hydrogen carrier gas and TMT, trimethylgallium (TMG) and arsine as the sources of the tin, gallium and arsenic, respectively, the various organic decomposition fractions interreact to directly form methane and excess hydrogen. Methane and hydrogen are both highly volatile and easily removable from the reactor system without contaminating the reactor chamber, epitaxial layer or the substrate.

Following the controlled decomposition of TMT along with trimethylgallium and arsine, tin is deposited onto the growth surface where it is both physically and electrically incorporated into the growing GaAs epitaxial layer. The physical incorporation of tin as a dopant into an epitaxial layer is generally limited to approximately the solid solubility of tin in the particular compound semiconductor material. For GaAs, the limit of tin solid solubility is between approximately $1 \times 10^{19}$ and $1 \times 10^{20}$ atoms/cm$^3$. Physical incorporation of tin at high concentrations, though obtainable, is subject to the time and temperature dependent process of solid precipitation of tin within the epitaxial layer. The physical incorporation of tin at concentrations of approximately $10^{20}$ atoms/cm$^3$ or less is not limited to any significant degree by surface kinetic effects at the growth surface of the epitaxial layer which, as when using other deposition techniques such as molecular beam epitaxy (MBE), results in the surface pile-up phenomenon. Consequently, the physical incorporation efficiency of tin is high throughout the conventional dopant concentration range of approximately $1 \times 10^{15}$ to $10^{20}$ atoms/$cm^3$.

The electrical incorporation efficiency of tin as a dopant is also quite high throughout the conventional range of dopant concentrations. Tin is a substantially non-amphoteric dopant species, particularly in GaAs, thereby resulting in very low self-compensation. Further, due to the uniform physical incorporation of tin, the electrical characteristics of a doped epitaxial layer are non-anomalous throughout the range of conventional doping concentrations.

The actual concentration of tin in an MOCVD grown epitaxial layer is largely dependent on a number of conventional reactor system variables that are all easily controllable. As discussed above, a principal variable is the mole fraction of TMT that is picked up by the carrier gas. The bubbler temperature, and therefore the vapor pressure of the TMT, and the particular method by which the carrier gas is passed by or through the TMT are directly controllable. Another system variable is the flow rate of the TMT bearing carrier gas into the reactor chamber. The higher the flow rate, the greater the quantity of TMT that is delivered into close proximity with the substrate and, consequentially, the higher the dopant concentration realized. Carrier gas flow rate is easily controllable by means of a mass flow control valve in the carrier gas feed line prior to the bubbler as typically provided in conventional MOCVD reactor systems. Finally, the growth rate of the epitaxial layer itself, as a system variable, directly impacts the concentration of tin incorporated into the epitaxial layer. For any given set of system variables, increasing the growth rate of the epitaxial layer will directly decrease the concentration of tin incorporated therein. Naturally, the growth rate of the epitaxial layer itself is dependent on, in the case of GaAs, the mole fractions of trimethylgallium and arsine present in the carrier gas, the corresponding carrier gas flow rate, and the temperature of the substrate.

The various parameters described above are readily determined for conventional MOCVD reactors and only require simple and ordinary experimentation. The Examples below illustrate that for such a reactor, tin dopant concentration is easily and reproducibly controlled over a substantial range.

Example 1

A GaAs epitaxial layer having a tin dopant concentration of approximately $8 \times 10^{18}$ atoms/$cm^3$ was grown on the surface of a GaAs substrate maintained at a temperature of approximately 700°C. Trimethylgallium, picked up by passing hydrogen through a bubbler containing liquid trimethylgallium at a temperature of −12°C at a flow rate of 23 $cm^3$/min, mixed with arsine, provided at a flow rate of 13.2 $cm^3$/min, and hydrogen, provided at a flow rate of 2,900 $cm^3$/min, was passed into an atmospheric pressure MOCVD reactor chamber to obtain an epitaxial growth rate of 0.1 μm/min. Tetramethyltin, picked up by passing hydrogen at a flow rate of 10 $cm^3$/min by the outlet tubes of a conventional bubbler configured as an effusion source with the tetramethyltin contained therein being maintained at a temperature of approximately −60°C, was further combined with the above mixture and passed into the reactor chamber, thereby providing for the epitaxial growth of a tin doped n-type GaAs layer.

By decreasing the epitaxial layer growth rate, increasing the temperature at which the tetramethyltin source is maintained, and by directly bubbling hydrogen gas through liquid tetramethyltin, tin doping concentrations in excess of $1 \times 10^{19}$ atoms/$cm^3$ of uniform physical and electrical qualities are reasonably obtainable.

Example 2

The same growth conditions were used as in the previous Example except that hydrogen, at a flow rate of 0.3 $cm^3$/min, was bubbled through the tetramethyltin source, maintained as a liquid at approximately −48°C, to obtain an n-type GaAs epitaxial layer having a tin dopant concentration of $3.4 \times 10^{18}$ atoms/$cm^3$.

Example 3

The same growth conditions were used as in the first Example except that the hydrogen flow rate by the effusion cell configured tetramethyltin source was reduced to 0.3 $cm^3$/min to obtain an n-type GaAs epitaxial layer having a tin dopant concentration of $7.2 \times 10^{17}$ atoms/$cm^3$.

Example 4

The same growth conditions were utilized as in the previous Example except that the temperature of the tetramethyltin source was reduced to between approximately −80° and −85°C and the flow rate of hydrogen by the effusion cell configured tetramethyltin source was further reduced to approximately 0.2 $cm^3$/min to obtain an n-type GaAs epitaxial layer having a tin dopant concentration of $9 \times 10^{16}$ atoms/$cm^3$.

Example 5

The same growth conditions were utilized as in the previous Example except that the temperature of the trimethyltin source was further reduced to approximately −110°C and the epitaxial layer growth rate was increased to 0.14 μm/min by water cooling the reactor chamber. The temperature of the water within the reactor chamber water jacket was maintained between 26° and 33°C. An n-type GaAs epitaxial layer, having a tin dopant concentration of $3.0 \times 10^{16}$ atoms/$cm^3$, was obtained.

By progressively reducing the tetramethyltin source temperature and further reducing the hydrogen flow rate by the outlet of the tetramethyltin effusion source, the MOCVD growth

of epitaxial layers of uniform physical and electrical qualities having tin dopant concentration significantly below $1 \times 10^{16}$ atoms/$cm^3$ can be reasonably obtained.

**Claims**

1. A process of epitaxially depositing in a metal-organic chemical vapor deposition (MOCVD) system including a reactor chamber, a layer of Group III—V compound semiconductor material having an n-type conductivity onto a substrate maintained within said reactor chamber, said process being characterized in that an elemental species which acts as a dopant to provide said layer with said n-type conductivity is obtained from the decomposition of a vapor phase organometallic compound consisting of tetramethyltin, wherein said tetramethyltin is conveyed into said reactor chamber by a carrier gas, the pick-up of said tetramethyltin from a source of tetramethyltin by said carrier gas being dependent upon the vapor pressure of said tetramethyltin source and the vapor pressure being variably controlled by controlling the temperature of said tetramethyltin source within the range of approximately −20.6° and −110°C while maintaining the temperature of the substrate between approximately 400° to 900°C during the epitaxial deposition of said layer.

2. The process of Claim 1 wherein the temperature of said tetramethyltin source is controlled within the range of approximately −48° and −110°C.

3. The process of Claim 1 or Claim 2 wherein said substrate is maintained at a temperature of approximately 700°C.

**Patentansprüche**

1. Verfahren zur epitaxialen Abscheidung in einem Metall-organischen-chemischen-Dampf-Abscheidungs-System (MOCVD-System) mit einer Reaktions-Kammer, wobei eine Schicht aus der Gruppe III bis V zusammengesetzten Halbleitermaterials mit n-Leitfähigkeit auf ein Substrat aufgebracht wird, welches sich in der Reaktionskammer befindet, dadurch gekennzeichnet, daß

durch den Zerfall einer Dampf-Phase einer metall-organischen Verbindung welche aus Tetramethyltin besteht ein Element erhaltbar ist, das als Dotierungsmittel wirkt um die Schicht mit der n-Leitfähigkeit zu erzeugen, wobei das Tetramethyltin durch ein Träger-Gas der Reaktions-Kammer zugeführt wird, das Aufnehmen des Tetramethyltin von einer Tetramethyltin-Quelle durch das Träger-Gas vom Dampfdruck der Tetramethyltin-Quelle abhängt und der Dampfdruck durch die Steuerung der Temperatur der Tetramethyltin-Quelle in einen Bereich von näherungsweise −20.6°C und −110°C variabel steuerbar ist, während die Temperatur des Substrates während der epitaxialen Abscheidung der Schicht näherungweise zwischen 400°C und 900°C gehalten wird.

2. Verfahren nach Anspruch 1, wobei die Temperatur der Tetramethyltin-Quelle in einen Bereich von näherungsweise −48°C und −110°C gesteuert wird.

3. Verfahren nach Anspruch 1 oder 2, wobei das Substrat auf einer Temperatur von näherungsweise 700°C gehalten wird.

**Revendications**

1. Un procédé pour effectuer un dépôt épitaxial, dans un système de dépôt chimique en phase vapeur organo-métallique (MOCVD) comprenant une chambre de réaction, d'une couche d'une matière semiconductrice composée du Groupe III—V, ayant une conductivité de type n, sur un substrat qui est maintenu dans cette chambre de réaction, ce procédé étant caractérisé en ce qu'une espèce élémentaire qui fait fonction de dopant pour donner à la couche la conductivité de type n, est obtenue par la décomposition d'un composé organométallique en phase vapeur consistant en tétraméthylétain qui est introduit dans la chambre de réaction par un gaz porteur, la proportion dans laquelle le gaz porteur capte le tétraméthylétain à partir d'une source de tétraméthylétain dépendant de la pression de vapeur de la source de tétraméthylétain et cette pression de vapeur étant commandée de façon variable par la commande de la température de la source de tétraméthylétain dans la plage d'environ −20,6° à −110°C, tout en maintenant la température du substrat entre environ 400°C et 900°C, pendant le dépôt épitaxial de la couche.

2. Le procédé de la revendication 1, dans lequel on commande la température de la source de tétraméthylétain dans la plage d'environ −48°C à −110°C.

3. Le procédé de la revendication 1 ou de la revendication 2, dans lequel on maintient le substrat à une température d'environ 700°C.